# FASCICULE DE BREVET EUROPEEN

(11) **EP 0 581 701 B1**
(45) Date de publication et mention de la délivrance du brevet: **21.05.1997**
(21) Numéro de dépôt: 93420320.9
(22) Date de dépôt: 27.07.1993
(51) Int. Cl.: H03F 3/45

(54) **Amplificateur différentiel CMOS à contre-réaction de mode commun**
CMOS-Differenzverstärker mit Gleichtaktgegenkopplung
CMOS differential amplifier with common-mode negative feedback

(30) Priorité: 30.07.1992 FR 9209795
(43) Date de publication de la demande: 02.02.1994
(73) Titulaire: SGS-THOMSON MICROELECTRONICS S.A., 94250 Gentilly (FR)
(72) Inventeur: Fensch, Thierry, F-38000 Grenoble (FR)
(74) Mandataire: de Beaumont, Michel

(56) Documents cités:
- EP-A- 0 138 261
- DE-A- 2 938 543
- US-A- 4 573 020
- US-A- 4 697 152
- US-A- 4 996 498
- IEEE JOURNAL OF SOLID-STATE CIRCUITS vol. 25, no. 6, Décembre 1990, NEW YORK pages 1414 - 1425 R. BATRUNI ET AL 'Mixed Digital-Analog Signal Processing for a Single-Chip 2B1QU Interface Transceiver'
- IEEE JOURNAL OF SOLID-STATE CIRCUITS vol. 25, no. 2, Avril 1990, NEW YORK pages 546 - 554 TOMASINI ET AL 'A fully differential CMOS Line Driver for ISDN'

## Description

La présente invention concerne le domaine des amplificateurs à entrée et sortie différentielles réalisés en technologie MOS à transistors complémentaires (CMOS) utilisant des transistors à canal N et des transistors à canal P.

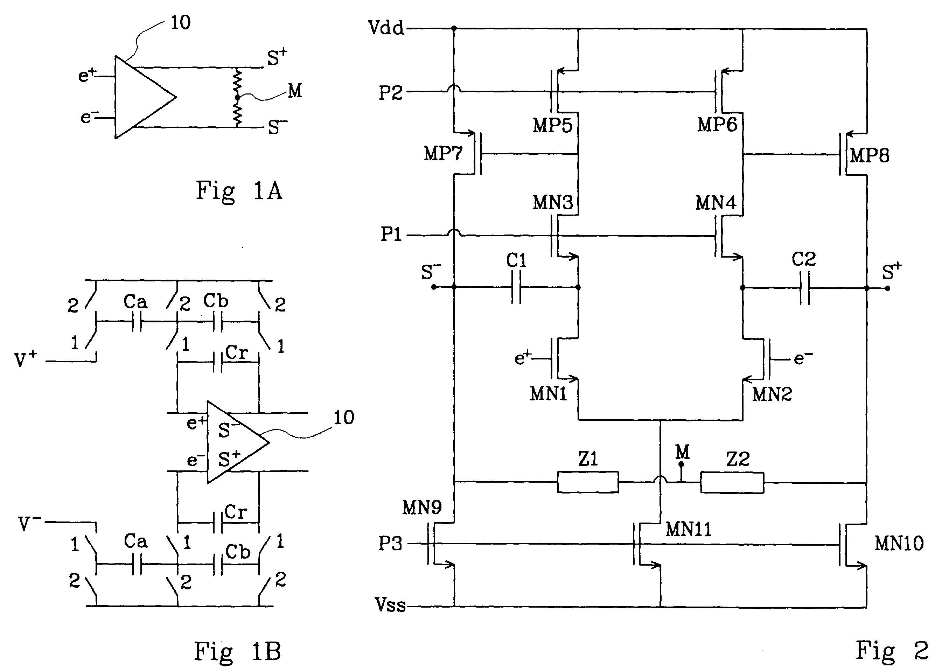

La figure 1A représente très schématiquement un tel amplificateur à entrée et sortie différentielles. Un amplificateur différentiel 10 est muni de deux entrées symétriques e⁺ et e⁻ et de deux sorties symétriques S⁺ et S⁻. Généralement, il est prévu entre les sorties S⁺ et S⁻ une charge (résistive ou capacitive) comprenant un point milieu M. Les tensions S⁺ et S⁻ sont symétriques par rapport à la tension VM au point milieu M. Un circuit de ce type est alimenté entre une borne d'alimentation haute Vdd et une borne d'alimentation basse Vss. Si VM est proche d'une de ces valeurs limites, cela réduit considérablement l'excursion de tension en sortie. On souhaite donc que VM soit proche d'une tension optimale de mode commun, VCM, qui doit avoir une valeur voisine de (Vdd-Vss)/2.

On utilise souvent ce type d'amplificateur dans des circuits dits à capacités commutées. Un exemple d'un tel circuit, constituant un intégrateur classique, est illustré en figure 1B. Ce circuit connu ne sera pas décrit en détail. On notera qu'il comprend des interrupteurs commutés à haute fréquence dont certains, marqués 1, sont commutés pendant une première phase d'un signal d'horloge et dont d'autres, marqués 2, sont commutés pendant une phase complémentaire du signal d'horloge. Des capacités de contre-réaction, Cr, sont connectées en permanence entre entrées et sorties complémentaires de l' amplificateur différentiel 10. Des capacités commutées Ca et Cb ont des valeurs très inférieures à celles des capacités de contre-réaction Cr.

La figure 2 représente à titre d'exemple, un mode de réalisation d'un amplificateur à entrée et sortie différentielles à deux étages. Dans ce qui suit, on désignera par MN des transistors MOS à canal N et par MP des transistors MOS à canal P.

L'étage différentiel d'entrée comprend deux transistors MOS MN1 et MN2 recevant respectivement sur leur grille les signaux d'entrée différentiels e⁺ et e⁻. Les drains des transistors d'entrée sont reliés par l'intermédiaire de charges respectives à la tension d'alimentation haute Vdd. On a illustré un étage de type cascode comprenant deux transistors cascode MN3 et MN4 dont la grille est connectée à une source de polarisation P1 et deux transistors de charge MP5 et MP6 dont la grille est connectée à une source de polarisation P2. De façon plus détaillée, la source de MN3 est reliée au drain de MN1, les drains de MP5 et de MN3 sont reliés et la source de MP5 est reliée à Vdd. De même, la source de MN4 est reliée au drain de MN2, les drains de MN4 et de MP6 sont interconnectés et la source de MP6 est reliée à Vdd. Les grilles de MN3 et MN4 reçoivent la polarisation P1 et les grilles de MP5 et MP6 reçoivent la polarisation P2.

Les sorties de cet étage différentiel d'entrée, prises aux points communs des drains des transistors MN3 et MP5 et des transistors MN4 et de MP6, respectivement, sont amplifiées par un étage différentiel de sortie comprenant des transistors MP7 et MP8 dont les sources sont reliées à Vdd et les drains à la tension d'alimentation basse Vss par l'intermédiaire d'une source de courant respective MN9 et MN10. Les grilles des transistors MN9 et MN10 sont reliées à une tension de polarisation P3 qui est également appliquée à la grille d'un transistor MN11 connecté entre les sources communes des transistors MN1 et MN2 et la tension Vss. Les sorties différentielles S⁻ et S⁺ du circuit correspondent respectivement aux drains des transistors MP7 et MP8.

Dans le cadre d'une technologie CMOS à substrat P, chacun des transistors MOS à canal P est réalisé dans un caisson N et le caisson est relié à la source du transistor, c'est-à-dire, dans de nombreux cas, à la tension Vdd.

On a également représenté dans la figure le point milieu M entre des impédances de sortie égales Z1 et Z2. Toute dissymétrie entre les entrées e⁺ et e⁻ par rapport à une tension prédéterminée de mode commun VCM entraîne un décalage de la tension VM au point M par rapport à la tension de mode commun choisie VCM.

Des condensateurs C1 et C2 agissent en tant que circuit de stabilisation et sont connectés respectivement entre les drains des transistors MN1 et MP7 et entre les drains des transistors MN2 et MP8.

L'homme de l'art notera que le circuit décrit est seulement illustratif d'un double étage différentiel et que de nombreuses variantes peuvent y être apportées. Par exemple, on pourra supprimer les transistors cascodes MN3 et MN4 mais alors il conviendra de rajouter une résistance série aux condensateurs de stabilisation C1 et C2. De nombreuses autres variantes peuvent être prévues pour améliorer le circuit quant à sa consommation, ou à sa sensibilité aux variations de température.

Etant donné la possibilité de décalage de la tension VM par rapport à la tension VCM, on prévoit généralement dans l'art antérieur des circuits de recentrage de la tension VM dits circuits de contre-réaction de mode commun.

Dans l'art antérieur, cette contre-réaction est souvent prévue sur l'étage de sortie ce qui présente plusieurs inconvénients parmi lesquels on peut mentionner :
- l'apparition d'une boucle de contre-réaction parasite entre l'étage de sortie et l'étage d'entrée ce qui oblige à prévoir des circuits de stabilisation supplémentaires,
- la consommation de l'étage de contre-réaction qui n'est pas négligeable puisqu'elle doit fournir des courants de l'ordre de grandeur des courants dans l'étage de sortie.

On a donc envisagé d'assurer la contre-réaction de mode commun au niveau de l'étage d'entrée. Le brevet américain 4697152 est illustratif de cette approche. La contre-réaction de mode commun est assurée au niveau des transistors de charge de l'étage différentiel. Par suite à une détection du décalage de mode commun, on agit sur les grilles des transistors de charge de chacune des branches différentielles. Cette solution présente encore plusieurs inconvénients. D'une part, elle introduit une constante de temps de réaction puisque les capacités de grille des transistors sur lesquels on agit introduisent un temps de retard. D'autre part, elle complique ou rend impossible l'utilisation d'un montage de charge de type cascode.

Une deuxième solution d'introduction de la réaction de mode commun sur l'étage d'entrée est proposée dans un article de Roy Batruni, Pierre Lemaitre et Thierry Fensch, paru dans IEEE Journal of Solid-State Circuits, Vol. 25, No. 6, Décembre 1990, pp. 1414-1425. Cette solution évite les inconvénients de lenteur de réaction et de difficulté d'insertion à l'étage cascode des solutions précédentes mais présente d'autres inconvénients qui seront détaillés ci-après.

Ainsi, un objet de la présente invention est de prévoir un circuit de contre-réaction de mode commun palliant les inconvénients de la dernière solution mentionnée.

Pour atteindre cet objet, la présente invention prévoit d'associer un circuit de contre-réaction de mode commun à l'étage d'entrée de l'amplificateur différentiel. La compensation est assurée par une branche en parallèle sur les branches de l'étage différentiel d'entrée et ajuste le courant dans ces branches d'entrée en fonction du déséquilibre de mode commun. Un transistor MOS maintenu en permanence à un état passant est disposé en parallèle sur chacun des transistors d'entrée.

Plus particulièrement, la présente invention prévoit un amplificateur CMO6 à entrée et sortie différentielles à au moins deux étages dans lequel l'étage d'entrée comprend deux branches dont chacune comprend un transistor d'entrée dont la première borne est reliée à une tension d'alimentation haute par une charge respective et dont les deuxièmes bornes sont reliées à la tension d'alimentation basse par une charge commune. Un étage de contre-réaction de mode commun comprend une charge connectée à la tension d'alimentation haute, un premier transistor connecté entre cette charge et la borne commune des transistors d'entrée, ce premier transistor étant polarisé à la tension de mode commun souhaitée, et un deuxième transistor connecté entre ladite charge et la tension d'alimentation basse et dont la grille est reliée à un potentiel indicatif de la tension moyenne de l'étage de sortie. Un transistor supplémentaire est en parallèle sur chacun des transistors d'entrée, ces transistors supplémentaires ayant leurs grilles à la tension de mode commun souhaitée.

Selon un mode de réalisation de la présente invention, les charges des branches d'entrée et de l'étage de contre-réaction sont constituées de transistors MOS à grille commune.

Selon un mode de réalisation de la présente invention, les charges des transistors d'entrée de l'étage d'entrée comprennent en outre des transistors en montage cascode.

Selon un mode de réalisation de la présente invention, les transistors d'entrée sont des transistors MOS à canal N de même que les transistors supplémentaires.

Ces objets, caractéristiques et avantages ainsi que d'autres de la présente invention seront exposés en détail dans la description suivante de modes de réalisation particuliers faite en relation avec les figures jointes parmi lesquelles :
les figures 1 et 2 décrites précédemment illustrent l'état de la technique ; et
la figure 3 représente un mode de réalisation d'un circuit selon la présente invention.

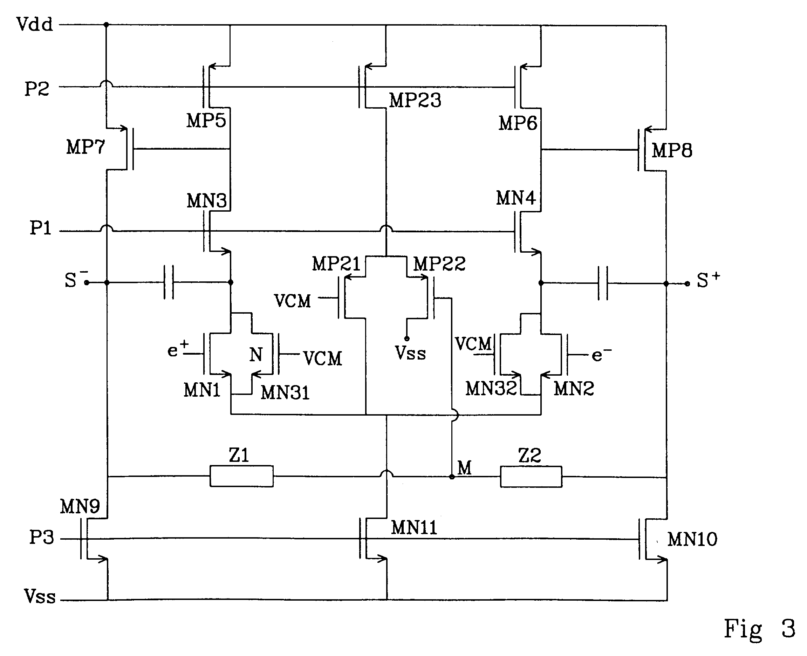

Le circuit illustré en figure 3 correspond pour partie au circuit de la figure 5 de l'article du IEEE Journal susmentionné. En relation avec cette figure 3, on va d'abord rappeler la structure et le fonctionnement du circuit, puis en souligner un inconvénient auquel la présente invention remédie.

la figure 3 représente un étage d'entrée associé à un étage de contre-réaction de mode commun comprenant des transistors MP21, MP22 et MP23 montés selon un schéma relativement classique pour l'homme de métier à savoir que les transistors MP21 et MP22 sont connectés sensiblement en étage différentiel, leurs sources étant interconnectées et reliées à la tension d'alimentation haute Vdd par l'intermédiaire d'un transistor de charge MP23 dont la grille est interconnectée avec les grilles des transistors MP5 et MP6. Le drain du transistor MP21 est relié aux sources communes des transistors MN1 et MN2 et sa grille est connectée à la tension de mode commun recherchée VCM. Le drain du transistor MP22 est relié à la tension d'alimentation basse Vss et sa grille est reliée au point milieu M. De préférence, le transistor MP23 a une surface dans un rapport k1 avec celle des transistors MP5 et MP6 de sorte que, quand chacun des transistors MP5 et MP6 est traversé par un courant I1, le transistor MP23 est traversé par un courant k1xI1. k1 peut par exemple être choisi de l'ordre de 1. De même, le transistor MN11 est choisi dans un rapport de surface déterminé k2 avec les transistors MN9 et MN10 pour limiter le courant dans l'étage d'entrée de sorte que, quand il passe I2 dans chacun des transistors MN9 et MN10, il passe un courant de l'ordre de k2xI2 dans le transistor MN11. k2 est par exemple choisi de l'ordre de 2,5.

L'étage de contre-réaction décrit précédemment fonctionne de la façon suivante. Quand les tensions e⁺ et e⁻ sont équilibrées par rapport à VCM et que VM = VCM, le courant dans le transistor MN11 est égal à k2xI2 et provient de la somme des courants dans les transistors MN1 et MN2 (2I1) et du courant dans le transistor MP21. Le courant de ce transistor MP21 est égal à k1xI1/2 puisque le courant I1 dans le transistor MP23 se répartit également entre les transistors MP21 et MP22 qui ont alors le même potentiel de grille. Si les potentiels des deux entrées e⁺ et e⁻ se décalent tous les deux dans le même sens (et non pas symétriquement comme ils le font normalement) les niveaux de sortie S⁺ et S⁻ se décalent dans la même direction et la tension VM n'est plus égale à la tension VCM. Si par exemple e⁺ et e⁻ se décalent positivement, VM croît d'où il résulte que le transistor MP22 devient moins conducteur et que davantage du courant de drain du transistor MP23 passera par le transistor MP21. Puisque la somme des courants dans MN1, MP21 et MN2 est constante et fixée par la polarisation du transistor MN11, cette augmentation du courant dans le transistor MP21 entraînera une diminution du courant dans les transistors MN1 et MN2 ce qui assure la compensation (ou contre-réaction) recherchée.

Le circuit décrit précédemment, qui correspond à la figure 5 de l'article de l'IEEE Journal susmentionné, présente un inconvénient rédhibitoire. En effet, il ne fonctionne pas et se bloque dans le cas où les deux tensions e⁺ et e⁻ chutent simultanément à la valeur basse Vss. Ceci peut se produire par exemple par suite de l'arrivée d'un parasite sur les conducteurs d'entrée, situation qui est loin d'être rare en pratique.

Ce blocage résulte du fait que, si les deux entrées e⁺ et e⁻ chutent à Vss, les deux transistors MN1 et MN2 se bloquent, ce qui entraîne le blocage des transistors MP7 et MP8 et donc la chute de la tension VM à une valeur proche de Vss. Le transistor MP22 est alors dans un état de conduction complète et dérive pratiquement tout le courant en provenance du transistor MP23. Une fois cet état amorcé, il se maintient car le potentiel des entrées e⁺ et e⁻ ne peut pas remonter assez haut pour repolariser correctement l'étage d'entrée. En effet, les contre-réactions qui existent toujours en pratique dans un montage d'amplificateur différentiel auront un effet prépondérant par rapport à la croissance progressive des entrées e⁺ et e⁻. Ceci est en particulier le cas dans des circuits de type à capacités commutées où les impédances de contre-réaction entre entrées et sorties de l'amplificateur différentiel (voir les capacités Cr de la figure 1B) ont des valeurs élevées et où les tensions e⁺ et e⁻ résultent de la charge de capacités (Ca en figure 1B) de petite valeur. On a donc bien un état de blocage.

La présente invention propose de modifier le circuit connu de contre-réaction de mode commun disposé au niveau de l'étage d'entrée en évitant la situation de blocage susmentionnée.

Plus particulièrement, la présente invention propose de disposer en parallèle sur chacun des transistors d'entrée MN1 et MN2 de l'étage d'entrée un transistor en parallèle, respectivement MN31 et MN32, les grilles de ces transistors parallèles étant connectées à la tension de référence de mode commun VCM.

Ainsi, si les deux tensions e⁺ et e⁻ chutent, les branches de l'étage différentiel d'entrée restent passantes par l'intermédiaire des transistors MN31 et MN32 et l'on ne trouve pas le phénomène de descente simultanée à zéro des deux sorties S⁺ et S⁻. La tension VM au point M reste supérieure à un seuil déterminé notamment par la surface relative des transistors MN31 et MN32 par rapport aux transistors MN1 et MN2.

Bien entendu, la présente invention est susceptible de nombreuses variantes et modifications qui apparaîtront à l'homme de l'art. Notamment, les transistors MOS à canal N et à canal P pourraient être intervertis à condition d'intervertir également les tensions d'alimentation haute et basse Vss et Vdd.

## Revendications

1. Amplificateur CMOS à entrée et sortie différentielles à au moins deux étages, dans lequel l'étage d'entrée comprend deux branches en parallèle comprenant chacune un transistor d'entrée (MN1, MN2) et une branche supplémentaire de contre-réaction de mode commun (MP23, MP21) en parallèle sur les branches d'entrée, caractérisé en ce qu'un transistor MOS (MN31, MN32) maintenu en permanence à un état passant est disposé en parallèle sur chacun des transistors d'entrée (MN1, MN2).

2. Amplificateur CMOS à entrée et sortie différentielles à au moins deux étages dans lequel l'étage d'entrée comprend
deux branches dont chacune comporte un transistor d'entrée (MN1, MN2) dont les premières bornes sont reliées à une tension d'alimentation haute (Vdd) par une charge respective et dont les deuxièmes bornes sont reliées à une tension d'alimentation basse (Vss) par une charge commune (MN11),
un étage de contre-réaction de mode commun comprenant une charge (MP23) connectée à la tension d'alimentation haute, un premier transistor (MP21) connecté entre cette charge et la borne commune des transistors d'entrée, ce premier transistor étant polarisé à la tension de mode commun souhaitée (VCM), et un deuxième transistor (MP22) connecté entre ladite charge et la tension d'alimentation basse (Vss) et dont la grille est reliée à un potentiel (VM) indicatif de la tension moyenne de l'étage de sortie,
caractérisé en ce qu'il comprend en outre un transistor supplémentaire (MN31, MN32) en parallèle sur chacun des transistors d'entrée (MN1, MN2), ces transistors supplémentaires ayant leurs grilles à la tension de mode commun souhaitée (VCM).

3. Amplificateur différentiel selon la revendication 2, caractérisé en ce que les charges des branches d'entrée et de l'étage de contre-réaction sont constituées de transistors MOS à grille commune (MP5, MP6, MP23).

4. Amplificateur différentiel selon la revendication 3, caractérisé en ce que les charges des transistors d'entrée de l'étage d'entrée comprennent en outre des transistors en montage cascode (MN3, MN4).

5. Amplificateur différentiel selon la revendication 4, caractérisé en ce que les transistors d'entrée sont des transistors MOS à canal N de même que les transistors supplémentaires (MN31, MN32).

## Patentansprüche

1. CMOS-Verstärker mit Differenzeingang und -ausgang mit wenigstens zwei Stufen, wobei die Eingangsstufe zwei Parallelzweige aufweist, deren jeder jeweils einen Eingangstransistor (MN1, MN2) und einen zusätzlichen Gleichtakt-Gegenkopplungszweig (MP23, MP21) parallel zu den Eingangszweigen aufweist,
dadurch gekennzeichnet, daß ein ständig in leitendem Zustand gehaltener MOS-Transistor (MN31, MN32) parallel zu jedem der Eingangstransistoren (MN1, MN2) vorgesehen ist.

2. CMOS-Verstärker mit Differenzeingang und -ausgang mit wenigstens zwei Stufen, wobei die Eingangsstufe umfaßt:
- zwei Zweige, deren jeder einen Eingangstransistor (MN1, MN2) aufweist, deren erste Anschlüsse mit einer hohen Speisespannung (Vdd) über eine jeweilige entsprechende Last verbunden sind und deren zweite Anschlüsse über eine gemeinsame Last (MN11) mit einer niedrigen Speisespannung (Vss) verbunden sind,
- eine Gleichtakt-Gegenkopplungsstufe, welche eine mit der hohen Speisespannung verbundene Last (MP23), einen zwischen dieser Last und einem gemeinsamen Anschluß der Eingangstransistoren liegenden ersten Transistor (MP21), wobei dieser erste Transistor mit der gewünschten Gleichtakt-Spannung (VCM) vorgespannt ist, sowie einen zweiten Transistor (MP22) aufweist, der zwischen der genannten Last und der niedrigen Speisespannung (Vss) liegt und dessen Gate mit einem die mittlere oder Durchschnittsspannung der Ausgangsstufe anzeigenden Potential (VM) verbunden ist,
dadurch gekennzeichnet, daß er des weiteren einen zusätzlichen Transistor (MN31, MN32) parallel zu jedem der Eingangstransistoren (MN1, MN2) aufweist, wobei an den Gate-Anschlüssen dieser zusätzlichen Transistoren die gewünschte Gleichtaktspannung (VCM) anliegt.

3. Differenzverstärker nach Anspruch 2,
dadurch gekennzeichnet, daß die Lasten der Eingangszweige und der Gegenkopplungsstufe von MOS-Transistoren mit gemeinsamem Gate (MP5, MP6, MP23) gebildet werden.

4. Differenzverstärker nach Anspruch 3,
dadurch gekennzeichnet, daß die Lasten der Eingangstransistoren der Eingangsstufe des weiteren Transistoren in Kaskodeschaltung (MN3, MN4) aufweisen.

5. Differenzverstärker nach Anspruch 4,
dadurch gekennzeichnet, daß die Eingangstransistoren N-Kanal-MOS-Transistoren sind ebenso wie die zusätzlichen Transistoren (MN31, MN32).

## Claims

1. A CMOS amplifier, with at least two-stages, a differential input and a differential output, wherein the input stage comprises two parallel legs, each comprising an input transistor (MN1, MN2) and an additional leg for a common mode negative feedback (MP23, MP21) in parallel with said input legs, characterized in that a MOS transistor (MN21, MN21) permanently maintained in a conductive state is disposed in parallel with each input transistor (MN1, MN2).

2. A CMOS amplifier with at least two stages, a differential input and a differential output, in which the input stage includes:
two legs, each of which includes an input transistor (MN1, MN2) having a first terminal connected to a high supply voltage (Vdd) through a respective load and a second terminal connected to a low supply voltage (Vss) through a common load (MN11),
a common mode negative feedback stage comprising a load (MP23) connected to the high supply voltage (Vdd), a first transistor (MP21) connected between said load and a common terminal of the input transistors, said first transistor being biased to a desired common mode voltage (VCM), and a second transistor (MP22) connected between said load and said low supply voltage (Vss), and having a gate connected to a voltage (VM) corresponding to the mean voltage of the output stage,
characterized in that it further comprises an additional transistor (MN31, MN32) disposed in parallel with each input transistor (MN1, MN2), each additional transistor having a gate connected to the desired common mode voltage (VCM).

3. The differential amplifier of claim 2, characterized in that the loads of the input legs and of the negative feedback stage are formed by MOS transistors (MP5, MP6, MP23) having a common gate.

4. The differential amplifier of claim 3, characterized in that the loads of the input transistors of the input stage further include cascode-connected transistors (MN3, MN4).

5. The differential amplifier of claim 4, characterized in that the input transistors and the additional transistors (MN31, MN32) are N-channel MOS transistors.
